(19) Europäisches Patentamt
European Patent Office
Office européen des brevets

(11) **EP 4 247 011 A1**

(12) **EUROPEAN PATENT APPLICATION**

(43) Date of publication:
**20.09.2023 Bulletin 2023/38**

(21) Application number: **22162454.7**

(22) Date of filing: **16.03.2022**

(51) International Patent Classification (IPC):
**H04S 7/00** (2006.01)   **G10L 21/0208** (2013.01)

(52) Cooperative Patent Classification (CPC):
**H04S 7/305; G10L 21/0208;** G10L 2021/02082;
H04R 2499/13

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Fraunhofer-Gesellschaft zur Förderung
der angewandten Forschung e.V.
80686 München (DE)**

(72) Inventors:
 • **Weber, Philipp
  91058 Erlangen (DE)**

 • **Uhle, Christian
  91058 Erlangen (DE)**
 • **Hölscher, Sarah
  91058 Erlangen (DE)**
 • **Bachmann, Thomas
  91058 Erlangen (DE)**
 • **Lang, Matthias
  91058 Erlangen (DE)**
 • **Gampp, Patrick
  91054 Erlangen (DE)**

(74) Representative: **Schairer, Oliver Michael et al
Schoppe, Zimmermann, Stöckeler
Zinkler, Schenk & Partner mbB
Patentanwälte
Radlkoferstraße 2
81373 München (DE)**

(54) **APPARATUS AND METHOD FOR AN AUTOMATED CONTROL OF A REVERBERATION LEVEL
USING A PERCEPTIONAL MODEL**

(57)    An apparatus for processing an audio input signal comprising one or more audio channels to obtain an audio output signal according to an embodiment is provided. The apparatus comprises a reverberation gain determiner (110) configured to determine reverberation gain information depending on the audio input signal. Moreover, the apparatus comprises a signal processor (120) configured to obtain the audio output signal depending on the reverberation gain information by adding artificial reverberation to the audio input signal or to a preprocessed audio signal, which depends on the audio input signal.

Fig. 1

EP 4 247 011 A1

**Description**

The present invention relates to audio signal processing, in particular, to an apparatus and a method for an automated control of a reverberation level, e.g., by using a perceptional model.

Reverberation is a very complex element in acoustics and audio signal processing and its perceived intensity and its control is of particular interest. Audio signals like musical recordings or radio broadcast may, e.g., be processed by means of artificial reverberation to emulate the acoustic properties of a specific environment, e.g., a concert venue or hall. Input signals may, e.g., be mixtures of direct signals and ambiance signals. Direct signals may, for example, be recordings of singing, musical instruments, and sound events like gun shots and alarm sirens. The term "direct sounds" indicates that these sounds are directional and can be localized as coming from one direction. Ambiance (or diffuse) sound components may, e.g., be reverberation and environmental sounds that are not being perceived as coming from specific directions, for example, wind noise and rain. In musical recordings, reverberation is the most prominent source of ambient sounds.

The perceived reverberation level depends on the input signal and reverberation impulse response, e.g., the length of the pre-delay and reverberation tail (see [1]). Nonstationary input signals with transients and fast attacks of the sub-band envelopes, e.g. drum sounds, produce a higher reverberation intensity.

Input signals with fastly decaying envelopes and silent portions are less effective in masking the reverberation (see [2]). When reverberation times and pre-delays are small, the input signal coincidences with and partially masks the reverberation signal to a larger extent as when reverberation times and pre-delays are large. Additionally, the acoustic environment (see [3]), the playback system (see [4]) and other aesthetic aspects related to the genre of the music influence the preferred gain parameter setting.

A model for predicting multiple spatial attributes tuned with listening test data has been described in [5], but the proposed model was not applied in real time and the model itself was also more complex as it used up to 12 audio features while yielding comparable performance to the provided algorithm which only uses 3 features. A model of perceived level of late reverberation in (see [6]) uses partial loudness of direct and reverberant components of the input audio signal. The study on the perceived level of artificial late reverberation in [1] showed that the perceived level depends on reverberation time and input signals but not on inter-channel correlation of the impulse response, and rating differences between individuals and repeated tests of the same individual were similar. The preferred level has been investigated in [7] where it has been concluded the aesthetic quality suffers more when the applied reverberation is above the preferred level than below.

The object of the present invention is to provide improved concepts for automatically controlling a reverberation level. The object of the present invention is solved by an apparatus according to claim 1, by a method according to claim 19 and by a computer program according to claim 20.

An apparatus for processing an audio input signal comprising one or more audio channels to obtain an audio output signal according to an embodiment is provided. The apparatus comprises a reverberation gain determiner configured to determine reverberation gain information depending on the audio input signal. Moreover, the apparatus comprises a signal processor configured to obtain the audio output signal depending on the reverberation gain information by adding artificial reverberation to the audio input signal or to a preprocessed audio signal, which depends on the audio input signal.

Furthermore, a method for processing an audio input signal to obtain an audio output signal according to an embodiment is provided. The method comprises:

- Determining reverberation gain information depending on the audio input signal. And:

- Obtaining the audio output signal depending on the reverberation gain information by adding artificial reverberation to the audio input signal or to a preprocessed audio signal which depends on the audio input signal.

Moreover, a computer program for implementing the above-described method when being executed on a computer or signal processor is provided.

In the following, embodiments of the present invention are described in more detail with reference to the figures, in which:

Fig. 1    illustrates an apparatus for processing an audio input signal comprising one or more audio channels to obtain an audio output signal according to an embodiment.

Fig. 2    illustrates a block diagram of a reverberation control algorithm according to an embodiment.

Fig. 3    illustrates average ratings per listening test item and total mean with 95% confidence intervals according to an embodiment.

Fig. 4 illustrates a predicted reverberation intensity over observed reverberation intensity according to an embodiment.

Fig. 5 illustrates in Fig. 5, top, a spectrogram of audio signal with transition from classical music to pop music after 25 s; in Fig. 5, middle, an equivalent reverberation level before and after temporal smoothing; and in Fig. 5, bottom, a smoothing coefficient and total scaling value according to an embodiment.

Fig. 6 illustrates a reference reverb send gain over equivalent reverberation level with fitted polynomial according to an embodiment.

Fig. 7 illustrates an equivalent reverberation level over reverb send gain error according to an embodiment.

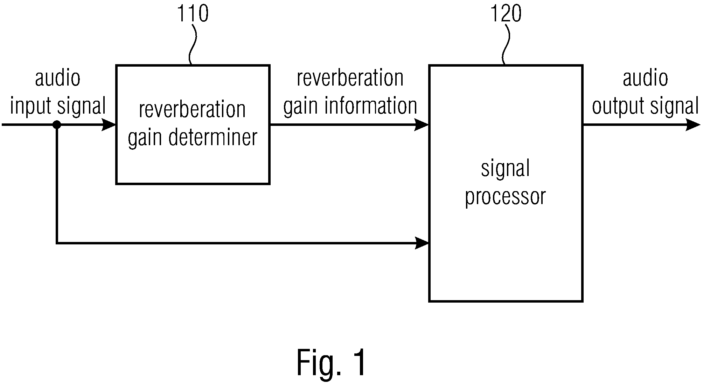

Fig. 1 illustrates an apparatus for processing an audio input signal comprising one or more audio channels to obtain an audio output signal according to an embodiment.

The apparatus comprises a reverberation gain determiner 110 configured to determine reverberation gain information depending on the audio input signal.

Moreover, the apparatus comprises a signal processor 120 configured to obtain the audio output signal depending on the reverberation gain information by adding artificial reverberation to the audio input signal or to a preprocessed audio signal, which depends on the audio input signal.

According to an embodiment, the reverberation gain determiner 110 may, e.g., be configured to determine the reverberation gain information depending on an estimate of a perceived intensity of reverberation in the audio input signal.

In an embodiment, the reverberation gain determiner 110 may, e.g., be configured to determine the reverberation gain information by employing a model that returns the estimate of the perceived intensity of reverberation in the audio input signal on receiving information on one or more features of the audio input signal.

According to an embodiment, the model employed by the reverberation gain determiner 110 may, e.g., be a linear regression model using one or more feature values of the one or more features of the audio input signal as an input for the linear regression model.

In an embodiment, to obtain the reverb send gain, the reverberation gain determiner 110 may, e.g., be configured to determine a reverb send gain as the reverberation gain information by mapping the estimate of the perceived intensity of reverberation in the audio input signal according to a mapping function. The equivalent reverberation intensity (= perceived intensity after application of scaling values) may, e.g., fed into the mapping function. For example, an estimate of a perceived intensity of reverberation is mapped to listening test data, and a respectively a fitted curve may, e.g., then be used for a conversion to a reverb send gain.

According to an embodiment, the one or more features of the audio input signal may, e.g., depend on an inter-channel correlation of at least one of one or more sub-bands of two audio channels of the one or more audio channels of the audio input signal.

In an embodiment, the one or more features of the audio input signal may, e.g., depend on an spectral flatness measure of at least one of one or more sub-bands of the one or more audio channels of the audio input signal.

According to an embodiment, the reverberation gain determiner may, e.g., be configured to determine the estimate of the perceived intensity of reverberation in the audio input signal by employing the model. The reverberation gain determiner may, e.g., be configured to determine one or more scaling factors depending on the one or more features of the audio input signal. Moreover, the reverberation gain determiner may, e.g., be configured to determine the reverberation gain information depending on the estimate of the perceived intensity of reverberation and depending on the one or more scaling factors.

In an embodiment, the one or more scaling factors may, e.g., depend on an inter-channel correlation of at least one of one or more sub-bands of two audio channels of the one or more audio channels of the audio input signal.

According to an embodiment, the one or more scaling factors may, e.g., depend on a presence of transient signal components in at least one of the one or more audio channels of the audio input signal.

In an embodiment, the one or more scaling factors may, e.g., depend on a spectral transient measure of at least one of the one or more audio channels of the audio input signal. The spectral transient measure may, e.g., be defined depending on:

$$STM(m,k) = \max\left( Z(m,k) - f_s(Z(m,k)), 0 \right)$$

wherein

$$Z(m,k) = g\left(\sum_{i=1}^{N} Y_d(m, b_{k,i})^2\right)$$

wherein m indicates a time index, wherein $k$ indicates a frequency index, and wherein $b_{k,i}$ indicates one of one or more frequency bins in frequency band/sub-band $k$, wherein $Y_d(m, b_{k,i})$ indicates a magnitude coefficient with time index m for the one or more frequency bins $b_{k,i}$ in frequency band $k$ of said at least one of the one or more audio channels or of a combination of said at least one of the one or more audio channels, and wherein $f_s()$ denotes a recursive averaging along time and implements a smoothing of the sub-band signal.

According to an embodiment, the signal processor 120 may, e.g., be configured to generate the preprocessed audio signal by dereverberating the audio input signal to attenuate original reverberation signal components of the audio input signal. The signal processor 120 may, e.g., be configured to obtain the audio output signal depending on the reverberation gain information by adding the artificial reverberation to the preprocessed audio signal.

In an embodiment, the signal processor 120 may, e.g., be configured to generate the preprocessed audio signal by conducting temporal smoothing of the audio input signal. The signal processor 120 may, e.g., be configured to obtain the audio output signal depending on the reverberation gain information by adding the artificial reverberation to the preprocessed audio signal.

According to an embodiment, the signal processor 120 may, e.g., be configured to adjust an amount of the temporal smoothing depending on changes in the audio input signal.

In an embodiment, the signal processor 120 may, e.g., be configured to adjust the amount of the temporal smoothing depending on changes in the audio input signal.

According to an embodiment, the signal processor 120 may, e.g., be configured to adjust the amount of the temporal smoothing depending on a change of a loudness of the audio input signal.

In an embodiment, the signal processor 120 may, e.g., be configured to adjust the amount of the temporal smoothing depending on changes in a variance of the one or more features of the audio input signal.

According to an embodiment, the apparatus may, e.g., comprise a ring buffer, e.g., with high length and/or high overlap, for real-time processing, which may, e.g., be configured to receive the audio input signal or the preprocessed audio signal. The signal processor 120 may, e.g., be configured to process the audio input signal or the preprocessed audio signal in the ring buffer to obtain the audio output signal.

In the following, particular embodiments are described. At first, an overview presenting an algorithm according to an embodiment may, e.g., be presented, then listening test and results including a statistical evaluation are provided. Moreover, a model for predicting perceived reverberation intensity according to an embodiment is provided, post processing using scaling factors according to an embodiment is presented, real-time application of a trained model according to an embodiment is described, and conversion to a reverb send gain is presented.

In some embodiments, the perceived intensity of reverberation in audio signals may, e.g., be estimated, and the level of an artificial reverberation signal may, e.g., be controlled, such that an artificially reverberated output signal may, e.g., have similar reverberation properties as the corresponding input signal. The estimation may, e.g., employ a linear regression model with sub-band Inter-channel Coherence and Spectral Flatness Measure as input features which is trained with listening test data. For the adaptation (e.g., for the application of the scaling factors), the artificial reverberation control signals may, e.g., be computed depending on temporal modulation properties and/or, e.g., depending on a correlation between the input channel signals and may, e.g., be applied to compute an equivalent reverberation level. The resulting quantity may, for example, be post-processed using signal-adaptive integration. The concepts may, e.g., be applied to control the reverb send gain of artificial reverberation used for sound reproduction in a car (reverb send gain: e.g., (send) gain of (artificial) reverberation).

Reverberation is a very complex element in acoustics and audio signal processing and embodiments focus on its perceived intensity and its control, for example, by adjusting the reverb send gain. Some embodiments may, e.g., be implemented independently from other aspects, e.g. frequency dependent reverberation times of the impulse response or its correlation across the channels. Other embodiments may, e.g., take these aspects into account.

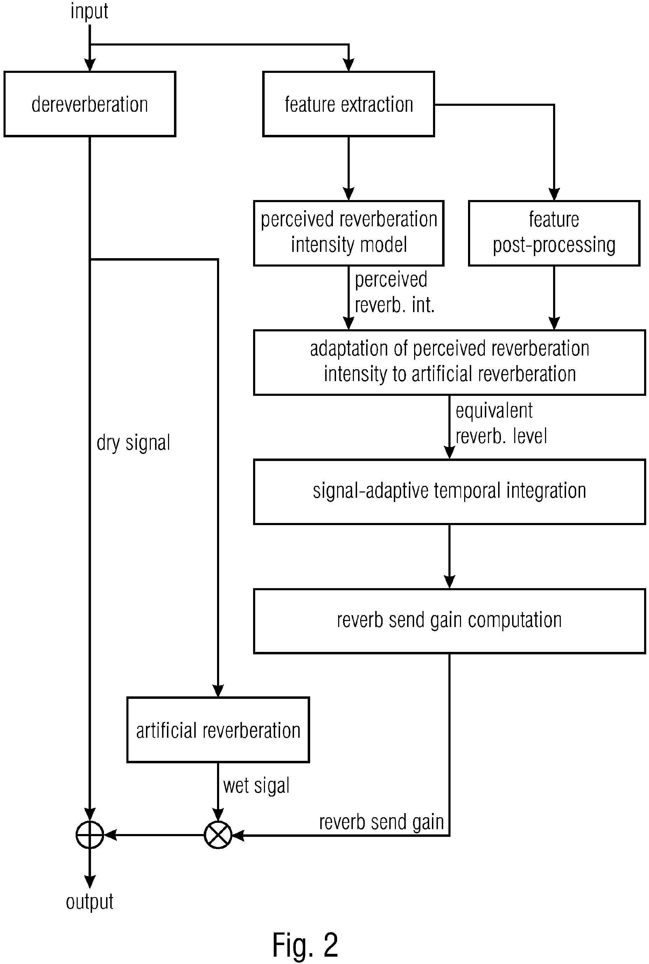

An schematic overview of a particular embodiment is shown in Fig. 2. The first stage may, e.g., comprise dereverberation and the extraction of audio features. In particular, Fig. 2 illustrates a block diagram of a reverberation control algorithm according to an embodiment. The feature values are input to a model for predicting the perceived reverberation intensity in the input signal. The model uses linear regression and is trained with listening test data. The model output is post-processed with signal-adaptive scaling factors which are manually tuned in respect to the properties of the newly added artificial reverberation to address the altered interaction of excitation signal and reverberation due to different characteristics of artificial and "original" reverberation. It should be noted that data-driven modelling of perceived reverberation intensity for the artificial reverberation (as is done for the original reverberation) would require listening test data for multiple parameter settings, and cannot be adapted when these settings are changed. Therefore, such an approach is not preferred.

The equivalent reverberation level is post-processed with signal-adaptive temporal integration in real-time. The result is applied to compute the reverb send gains using a function fitted to preferred send gains adjusted by expert listeners. The computed reverb send gain controls the level of artificial reverberation applied to the dereverberated input signal. Dereverberation is applied to attenuate reverberant signal components of the input because adding artificial reverberation to an input signal with large amounts of "original" reverberation results in loss of clarity or the perception of too much reverberation or an aesthetically undesired superposition of two reverberation signals.

In the following, results of a listening test are presented.

In the listening test 27 loudness normalized audio signals with a duration between 4.8 s to 14.7 s were presented. The items were chosen such that only small changes of the spatial cues (amount of reverberation and energy distribution in the stereo panorama) were apparent. The set of items ranges from very dry to very reverberant and includes recordings of various music genres as well as recordings of solo instruments and dry speech recordings.

The participants were asked to rate the perceived reverberation intensity and the width of ensemble by adjusting a slider on a discrete unipolar scale ranging from 1 to 9. The labels "Very low", "Low", "Medium", "High" and "Very High" were evenly distributed on the scale. The additional attribute, width of ensemble, was provided to make it easier for the listener to judge the reverberation intensity independently of the stereo panorama. The test starts with training session where three stimuli were presented to give examples of, e.g., low amount of reverberation and high width of ensemble, and vice versa. 15 listeners participated in the test.

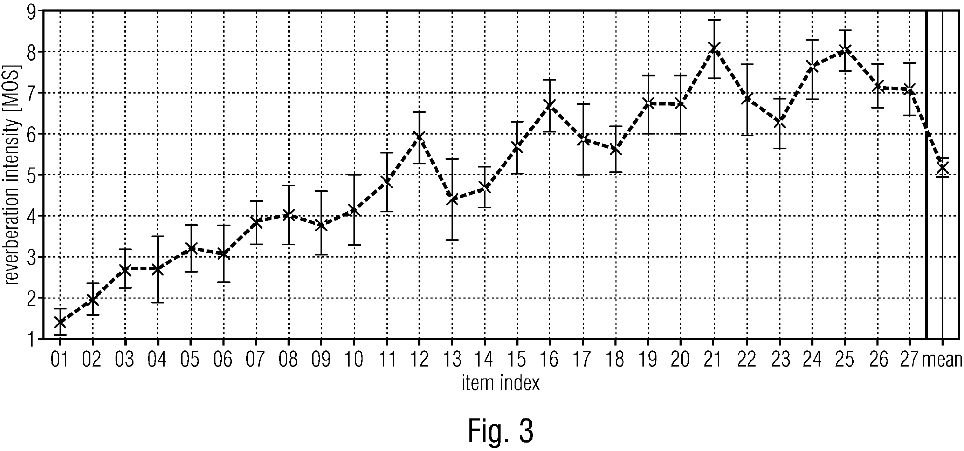

Fig. 3 illustrates average ratings per listening test item and total mean with 95% confidence intervals according to an embodiment. In particular, Fig. 3 shows mean values and 95% confidence intervals of the reverberation rating. The confidence intervals were obtained according to

$$\hat{\mu} \pm t_{\alpha/2,n-1} \cdot \frac{\hat{\sigma}}{\sqrt{n}} \qquad (1)$$

with $\hat{\mu}$ m being the estimated mean, $t_{\alpha/2,n-1}$ the $\alpha/2$ quantile (here $\alpha = 0.05$) from a t-distribution with $n - 1$ degrees of freedom, $\hat{\sigma}$ the estimated standard deviation and $n$ the sample size [8].

In the following, a linear regression model according to an embodiment is presented.

In the following, a computational model for predicting perceived reverberation intensity of an audio signal and its training according to particular embodiments is described.

At first, a model description according to an embodiment is provided.

A linear regression model is applied to estimate perceived reverberation intensity $\hat{r}$, as linear combination of input features $x_k$ as

$$\hat{r} = \sum_{k=1}^{K} \beta_k \cdot x_k + \beta_0 \qquad (2)$$

with model coefficients $\beta_k$, bias value $\beta_0$, and number of input features $K$.

Now, audio feature extraction according to an embodiment is described.

Input to the linear regression model are sub-band Inter-channel Coherence (ICC) and Spectral Flatness Measure (SFM) computed from short-term Fourier transform (STFT) coefficients. ICC is computed in 5 and SFM in 4 frequency bands as shown in Table 1.

Table 1 illustrates a frequency band separation of ICC and SFM according to an embodiment.

| (Table 1) | | |
|---|---|---|
| Frequ. band | ICC | SFM |
| 1 | 70 Hz - 164Hz | 70 Hz - 305Hz |

(continued)

| Frequ. band | ICC | SFM |
|---|---|---|
| 2 | 164 Hz - 445Hz | 305 Hz - 680Hz |
| 3 | 445 Hz - 4.9kHz | 680 Hz - 1.4kHz |
| 4 | 4.9 kHz - 11kHz | 1.4 kHz - 21kHz |
| 5 | 11 kHz - 21kHz | |

The STFT coefficients are computed from audio signals sampled at 48 kHz with frame size of 1024 samples, hop length of 512 samples, and without zero padding. STFT frames with a loudness below -65 LUFS (loudness units relative to full scale) were removed to make the training of the model agnostic to periods of silence, e.g., speech pauses. ICC [9] is computed from both channel signals of the 2-channel stereo input signal according to

$$ICC(m,k) = \left| \frac{Y_{1,2}(m,k)}{\sqrt{Y_{1,1}(m,k) \cdot Y_{2,2}(m,k)}} \right| \tag{3}$$

with $Y_{1,1}(m, k)$ and $Y_{2,2}(m, k)$ being the auto power spectral densities (PSDs) of left and right channel, respectively, and $Y_{1,2}(m, k)$ being the cross PSD where all PSDs are accumulated over frequency bins corresponding to the k-th frequency band at time index m. For example, with $b_k(i, 1)$ indicating an $i$-th complex spectral bin of the k-th frequency band of a first audio channel of the audio input signal, and with $b_k(i, 2)$ the i-th complex spectral bin of the k-th frequency band of a second audio channel of the audio input signal, then $Y_{1,1}(m,k)$, $Y_{1,2}(m,k)$ and $Y_{2,2}(m,k)$ may, for example, be defined as follows:

$$Y_{1,1}(m,k) = \sum_{i=1}^{N} b_k(m,i,1) \, b_k(m,i,1)^*$$

$$Y_{1,2}(m,k) = \left| \sum_{i=1}^{N} b_k(m,i,1) \, b_k(m,i,2)^* \right|$$

$$Y_{2,2}(m,k) = \sum_{i=1}^{N} b_k(m,i,2) \, b_k(m,i,2)^*$$

with $b_k(m, i, 1)^*$ indicating the complex conjugate of $b_k(m, i, 1)$, and with $b_k(m, i, 2)^*$ indicating the complex conjugate of $b_k(m, i, 2)$, with time index m. $N$ may, e.g., indicate the number of the downmixed squared STFT magnitude coefficients for frequency bins $b_k$ in frequency band $k$.

For example, in a particular embodiment, a frequency band may, e.g., comprise one or more frequency bins per audio channel (For example, in a particular embodiment, a frequency band may, e.g., be just a single bin). E.g., in a particular embodiment, formula (3) may, e.g., be employed to obtain an inter-channel correlation for said frequency band.

SFM (see [10]) is computed as ratio of geometric mean to arithmetic mean according to

$$SFM(m,k) = \frac{\left(\prod_{i=1}^{N} X(m,k,i)\right)^{\frac{1}{N}}}{\frac{1}{N}\sum_{i=1}^{N} X(m,k,i)} \tag{4}$$

with

$$X(m,k,i) = g\left(Y_d(m, b_{k,i})^2\right) \tag{5}$$

where $g()$ is a compressive function, e.g., the logarithm, or the square root, or $y = x^{0.25}$, and $Y_d(m, b_{k,i})^2$ are the downmixed squared STFT magnitude coefficients of the left and right input channel for i-th frequency bins $b_{k,i}$ in frequency band $k$ consisting of $N$ bins, with time index m. (Thus, $N$ may, e.g., indicate the number of frequency bins $b_{k,i}$ in frequency band $k$.) For example, in an embodiment with two audio channels, the downmixed squared STFT magnitude coefficients $Y_d(m, b_{k,i})^2$ may, e.g., result from squaring the downmixed STFT magnitude coefficients $Y_d(m, b_{k,i})$, and the downmixed STFT magnitude coefficients $Y_d(m, b_{k,i})$ may, e.g., result from combining (for example, averaging) the magnitude coefficients of the two audio channels of a frequency bin of the k-th frequency band.

In embodiments, features were extracted for each frame (e.g., for each block) and subsequently the arithmetic mean and standard deviation were computed to obtain blockwise single values, which were then used in the training of the regression model.

For example, each block may, for example, comprise audio data for replaying one second of an audio recording. A block may, for example, comprise spectrum data for 94 points-in-time (e.g., for 94 frames assuming that a frame may, e.g., have, in a particular embodiment, a duration of 21.3 milliseconds, e.g., about 94 frames/second, when the frames have 50 % overlap). In other embodiments, a block may, for example, comprise spectrum data for any other number of points-in-time. In an example, the spectrum may, e.g., be divided into five frequency bands and/or, e.g., into four frequency bands, for example, as outlined in table 1.

For example, considering the ICC, for each of the, e.g., five frequency bands of, e.g., table 1, and for each of the, e.g., 94 points-in-time, an ICC value is determined. For each of the, e.g., five frequency bands, an arithmetic mean of the, e.g., 94 ICCs of a block is determined and thus, five arithmetic-mean ICC values for the five frequency bands may, e.g., result. And/or, for each of the, e.g., five frequency bands, a standard deviation of the, e.g., 94 ICCs of the block is determined and thus, five standard-deviation ICC values for the five frequency bands may, e.g., result. By this, e.g., 10 ICC-related feature values result for the, e.g., five frequency bands for a block.

For example, considering the SFM, for each of the, e.g., four frequency bands of, e.g., table 1, and for each of the, e.g., 94 points-in-time, an SFM value is determined. For each of the, e.g., four frequency bands, an arithmetic mean of the, e.g., 94 SFM of a block is determined and thus, four arithmetic-mean SFM values for the four frequency bands may, e.g., result. And/or, for each of the, e.g., four frequency bands, a standard deviation of the, e.g., 94 ICCs of the block is determined and thus, four standard-deviation SFM values for the four frequency bands may, e.g., result. By this, e.g., 8 SFM-related feature values result for the, e.g., four frequency bands for a block.

Regarding the combination of both the ICC example and the SFM example, e.g., 18 feature values for a block may, for example, result.

Now, model training according to an embodiment is described.

Processing short blocks of data is vital for real-time processing, especially for nonstationary signals, and to increase the available amount of training data. Each item was windowed with training block length of 6 s with zero overlap. Items which were shorter in length than 12 s were processed in its entire length as single block. The performance when training with overlapping blocks has also been evaluated without observing an improvement of the model accuracy.

The training data set has been extended by adding a second excerpt with similar spatial characteristics for some songs used in the listening test. Additional, several critical items, whose predictions were inadequate, were added with reference ratings provided by a single expert listener. To ensure that the model predicts small values for dry and clean speech signals, recordings of male and female speakers were added to the data set with reference annotations set to -1MOS (mean opinion score). Extending the data set and using multiple blocks for each item yielded 100 observations in total.

For having the opportunity to consider nonlinear relations between listening test data and feature values, exponentiation was applied to the means and standard deviations of the feature values. The exponent was determined by manual tuning based on evaluation of the residual plot, which reveals nonlinearities that by definition cannot be modelled by linear regression.

The training of the model was performed with an ordinary least squares (OLS) algorithm which minimizes the mean squared error between predictions $\hat{r}$ and mean ratings obtained in the listening test. The evaluation was carried out with a leave-one-out cross-validation [11] where the model is trained with all observations but one and evaluated with the left out item. This procedure is repeated for each item.

Now, feature selection according to an embodiment is described.

The training was started with all available values, e.g., arithmetic average and standard deviation per sub-band feature. A sub-band feature may, e.g., be the ICC or the SFM for said sub-band (frequency band).

In order to avoid overfitting and reduce computational load, the non-beneficial independent variables were removed one by one by evaluating the p-values. Low p-values indicate that there is most likely no relationship between the corresponding feature value and the listening test result (see [11]).

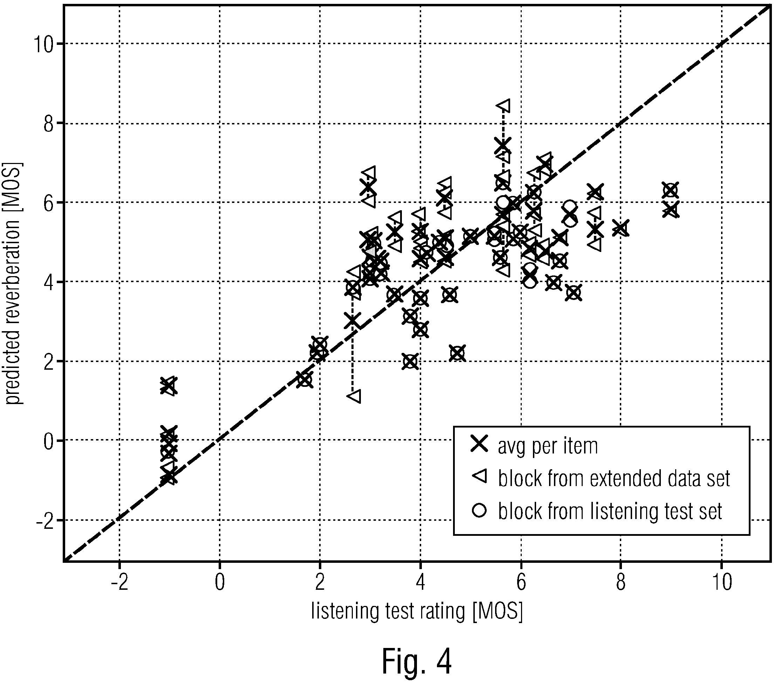

For example, in the above example with 18 feature values (10 ICC related feature values and 8 SFM related feature values), a gradual removal of all irrelevant feature values may, for example, result in a model with 4 input variables (for example, the 14 other irrelevant or less relevant input variables/feature values may, e.g., be gradually removed, e.g., by conducting a multivariate regression analysis (see, e.g., [11]). The performance of this model is displayed in Fig. 4.

In particular, Fig. 4 illustrates a predicted reverberation intensity over observed reverberation intensity according to an embodiment. The predictions of the training blocks of listening test items are displayed with dots and the predictions obtained for the training blocks of the extended data set (items from extended data set) are represented with triangles. Average predictions per item are shown with crosses. Markers representing blocks of the same item have the same listening test rating. The plot reveals a good correlation of predictions and observations with a correlation coefficient of 0.75 and a mean average error of 1.27MOS. For listening test ratings around 3MOS there is a tendency towards too high values while high ratings are slightly under estimated.

In the following, a reverb send gain computation according to an embodiment is provided. In particular, the computation of a preferred reverb send gain of artificial reverberation given the perceived intensity of primary reverberation in the input signal is described. As original reverberation (of the input signal) and the secondary (artificial) reverberation do not match, equal reverberation level can result in different perceived reverberation intensity. Therefore the reverb send gain cannot be directly computed given the perceived reverberation intensity.

Data-driven modelling of perceived intensity for artificial reverberation is not feasible because it requires subjective data for different reverberation settings.

In embodiments, manually tuned scaling factors $s_t$ and $s_c$ are introduced to compensate for signal-dependent effects, for example, as described in the following. For the description of the processing, an intermediate quantity, the equivalent reverberation level $\hat{r}_e$, is defined as

$$\hat{r}_e = \hat{r} \cdot s_t \cdot s_c. \qquad (6)$$

Equivalent reverberation level represents the desired level of artificial reverberation for a given input signal which results in similar reverberation intensity of artificial and original reverberation. The equivalent reverberation level is subsequently converted into a reverb send gain using a mapping function, determined in a separate adjustment experiment.

Now, aspects of the equivalent reverberation level according to embodiments are described.

Signals with strong transients, e.g., drum sounds, lead to a higher perceived reverberation intensity than stationary signals and are less effective in masking the reverberation.

Artificial reverberation with large time constants may require lower reverberation level to evoke similar intensity perception as the original reverberation. Some embodiments provide a novel spectral transient measure (STM) for quantifying the intensity of transients in a signal as

$$STM(m,k) = \max \Big( Z(m,k) - f_s(Z(m,k)), 0 \Big) \qquad (7)$$

with

$$Z(m,k) = g\left(\sum_{i=1}^{N} Y_d(m, b_{k,i})^2\right) \qquad (8)$$

$f_s()$ denotes a recursive averaging along time and implements a smoothing of the sub-band signal.

For example, in a particular embodiment, the frequency bands may, for example, be the frequency bands of table 1, left column, or of table 1, right column. Other frequency bands/frequency band configurations may, e.g., alternatively be employed. Each of the frequency bands may, e.g., then comprise all, e.g., time-frequency bins within said frequency band for time index m.

The STM single value is obtained by averaging the STM values of frequency band from 23 to 70 Hz and 5.2 to 21 kHz. This band selection focuses on transients caused by percussive instruments while those of other instruments, e.g., piano, are considered less.

The scaling factor $s_t$ is computed from the STM as

$$s_t = m_t \cdot 10\log_{10}(\overline{STM}) + n_t \qquad (9)$$

where *STM* denotes the mean of the STM value of blocks of 1 s length subsequently clipped according to

$$s_{t,min} \le s_t \le s_{t,max} \qquad (10)$$

with $m_t$, $n_t$, $s_{t,min}$ and $s_{t,max}$ being tunable parameters which are adjusted depending on properties of the artificial reverberation.

If the reverberation time of the "original" reverberation exceeds the one of the artificial reverberation, larger equivalent reverberation level is required. The second scaling factor $s_c$ is designed to adjust the estimated reverberation intensity for input signals containing a high amount of reverberation with a long reverberation time, e.g., classical music. It is assumed that such items are rather decorrelated due to the high amount of diffuse sound components. The scaler $s_c$ is computed as

$$s_c = m_c \cdot \overline{ICC} + n_c \qquad (11)$$

where *ICC* is the mean value of the ICC of all frequency bands and frames in blocks of 1 s length, and subsequently clipped according to

$$s_{c,min} \le s_c \le s_{c,max} \qquad (12)$$

with $m_c$, $n_c$, $s_{c,min}$ and $s_{c,max}$ being tunable parameters.

In the following, signal-adaptive temporal integration according to embodiments is described.

For controlling the reverberation send gain in real-time it is desired to react to changes in the input signal while not introducing noticeable modulations of the reverberation level. To address this with low latency and low computational load the predictions are computed from blocks of 8 s length each with an overlap of 7 s such that new predictions are computed with a rate of 1 Hz. Signals with low input levels, e.g. below -65 LUFS, are not fed to the model as done during training. The equivalent reverberation level $\hat{r}_e(n)$ (6) is temporally smoothed using recursive averaging with a single pole IIR filter,

$$\hat{r}_{e,s}(n) = \alpha \cdot \hat{r}_e(n) + (1-\alpha) \cdot \hat{r}_{e,s}(n-1) \qquad (13)$$

with smoothing coefficient a.

To avoid too large reverberation levels at transitions between input signals with very different characteristics, track changes are detected and a fast adaptation of the equivalent reverberation level is implemented. Fast adaptation is done by reducing the models block length to 1 s and increasing smoothing coefficient a. For the detection, changes in the variance of STM are identified as a change in the amount of transients is a good indicator for a transition from, e.g., music to speech, requiring a much lower reverberation level.

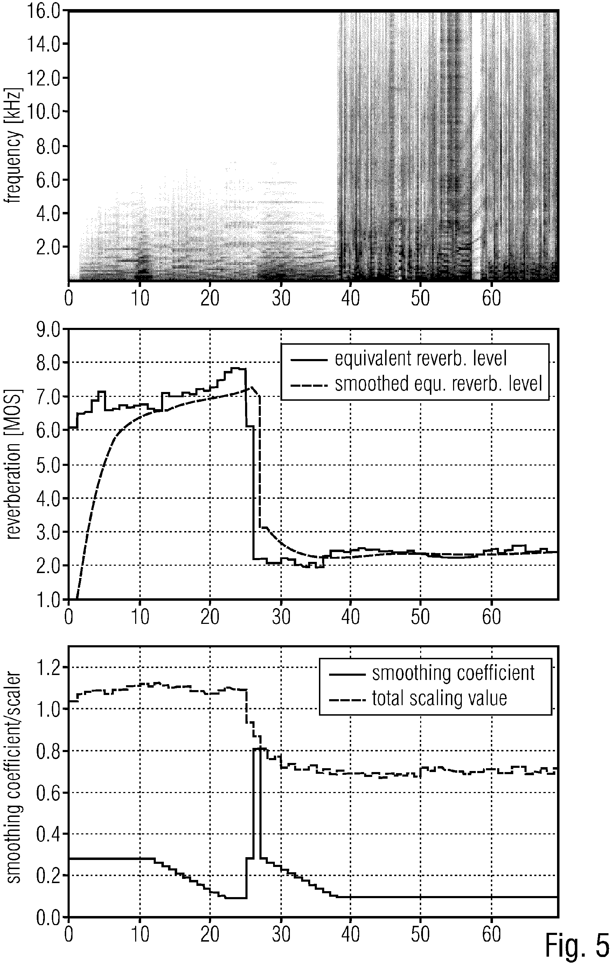

Fig. 5 illustrates a real-time processing of an explanatory input file which consists of 25 s of classical music and an abrupt transition to pop music which can be observed in the upper plot showing the spectrogram according to an embodiment. In particular, Fig. 5, top, illustrates a spectrogram of audio signal with transition from classical music to pop music after 25 s. Fig. 5, middle, depicts an equivalent reverberation level before (solid) and after (dashed) temporal smoothing. Fig. 5, bottom, shows a smoothing coefficient (solid) and total scaling value (dashed).

The middle subplot depicts equivalent reverberation level before (solid) and after (dashed) temporal smoothing with a value around 7MOS for classical music and 2.2MOS for the pop item. The lower subplot shows the product of the scaling values ($s_t \cdot s_c$) referred to as total scaling value as dashed line. Due to low correlation of the classical music item, the total scaling value is higher than 1 until the track change. The increase in amount of transients at $t = 25s$ triggers the track change detection and reduces the total scaling value to about 0.7.

The smoothing coefficient a, plotted with a solid line in the lower subplot, decreases after an adjustment phase of 11 s, as loudness and equivalent reverberation level are then rather stationary. The track change detection at t = 25s temporarily increases $\alpha$ and results in fast adaption of the equivalent reverberation level.

Now, a conversion from reverberation prediction into reverb send gain according to embodiments is described.

E.g., as a final step, the send gain of the reverberation processor may, e.g., be computed given the equivalent reverberation level. To this end a second listening test has been performed where 5 expert listeners adjusted the send gains of two artificial reverberations simulating the acoustical environment of a concert hall (T60 = 2.2s) and a jazz club (T60 = 1.3s) inside a car according to their preference.

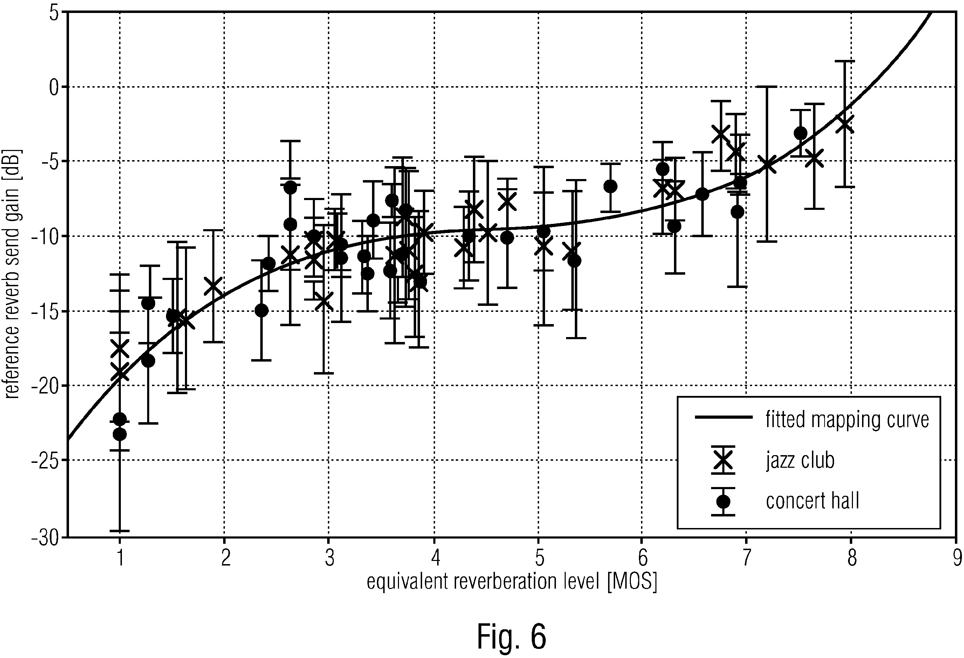

Fig. 6 illustrates a reference reverb send gain over equivalent reverberation level with fitted polynomial according to an embodiment. In particular, Fig. 6 depicts the obtained average send gain over equivalent reverberation level with 95% confidence intervals according to Equation (1) for all 30 test items for the two artificial reverberations. As a longer reverberation tail leads to less masking and higher perceived reverberation intensity with transients requiring a lower reverb send gain, the tunable parameters in Equation (9) and Equation (11) were adjusted such that strong transients and low correlation lead to lower equivalent reverberation level for concert hall in comparison to jazz club. As a result one single mapping curve can be used for both reverberations. With a value of 0.81 the Spearman's rank correlation coefficient confirms a monotonic relationship between the two variables which can be approximated with a polynomial of degree 3 with a low error.

The gain, adjustments were used to fit a polynomial mapping

$$g = a\hat{r}_{e,s}^3 + b\hat{r}_{e,s}^2 + c\hat{r}_{e,s} + n$$

shown in Fig. 6 which translates the smoothed equivalent reverberation level $\hat{r}_{e,s}$ into a predicted reverb send gain $g$.

In the following, evaluation aspects are considered.

For evaluating the polynomial mapping, the leave-one-out cross-validation technique is used, meaning that all value pairs but one were used to fit the polynomial function and the last data pair served for obtaining the error for this specific data point. This process was repeated for all listening test items with mean absolute error (MAE) of 1.74 dB. According to [7] such a deviation from the preferred reverb send gain results in a negligible reduction in aesthetic quality. The limits of the 95% confidence interval, obtained according to Equation (1), lie at 1.27 dB and 2.21 dB. The absolute maximum error corresponds to 5.11 dB and the correlation between predicted and observed values lies at 0.89.

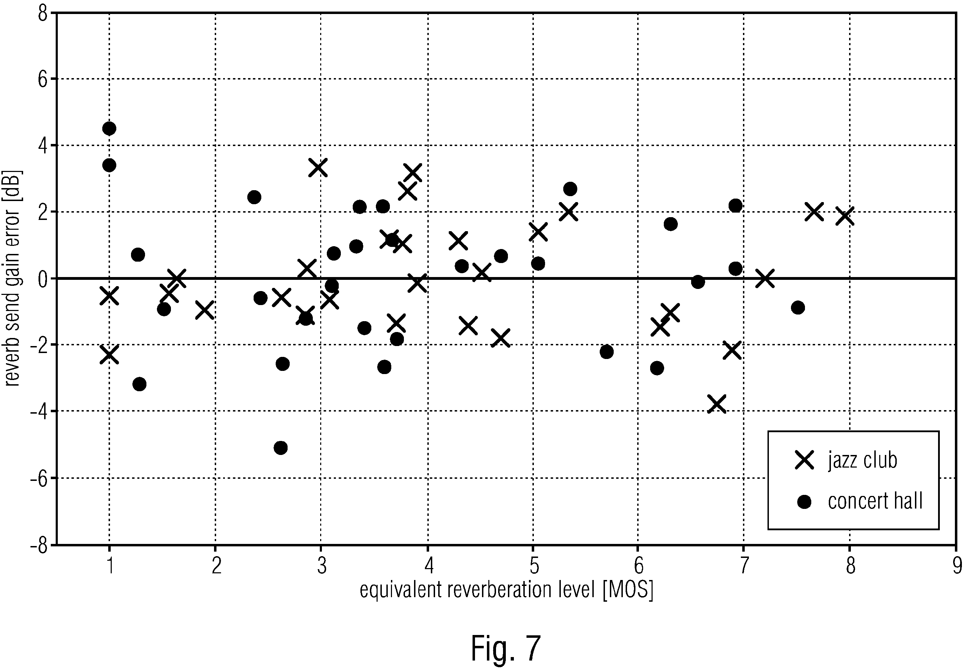

Fig. 7 illustrates an equivalent reverberation level over reverb send gain error according to an embodiment. The scatter plot depicted in Fig. 7 shows reverb send gain error over equivalent reverberation level revealing an even distribution of the errors above the whole value range with only one outlier at 2.6 MOS.

Concepts for controlling the level of artificial reverberation have been provided. Some of the provided concepts may, e.g., employ a model for predicting the perceived reverberation intensity based on a linear regression model trained with listening test data. The method uses manually tuned adaptations to various parameter settings of the artificial reverberation. Fast adaptation to changes in the input signal characteristics is implemented by signal-adaptive temporal integration. The algorithm was evaluated in the application of in-car sound reproduction and is capable of predicting preferred reverb send gains with a MAE of 1.74 dB.

Extensions of the above-described provided embodiments are now described.

For example, other application scenarios may, e.g., be realized.

Embodiments may, e.g., be applied for controlling the reverberation in various other application scenarios. In binaural sound reproduction artificial reverberation is applied to support the sensation of externalization, e.g., that the listener localizes sound events, objects and sources outside of the head. This is in contrast to standard sound reproduction with headphones where typically sounds are perceived as coming from inside of the head.

Artificial reverberation is used in music production where it is applied to a mixture of multiple sound sources and individual sound sources. The proposed method can also be extended to predict the perceived amount of reverberation for individual sound sources or individual components of a mixture signal (e.g. a group of sound sources). The information on the amount per individual component enables automated control or artificial reverberation in sound production (music production, movie sound, podcasts and other user generated content).

Other embodiments may, e.g., implement alternative models.

The linear model may, e.g., be replaced by other data-driven models, e.g., by any function

$$\hat{y} = f(\mathbf{x}, \Theta),$$

where a scalar output $\hat{y}$ is computed given an input vector $\mathbf{x}$ and model parameters $\Theta$ which are determined by optimizing a criterion (e.g. minimizing a mean square error) between $\hat{y}$ and target outputs $y$. Another well-known class of such trainable models are artificial neural networks, in particular deep neural networks (DNN). It needs to be noted that the larger the set of parameters $\Theta$ is, the more data is required for training of the model such that the performance is not only good for the training data but also for new data pairs $(x, \hat{y})$ that have not been used during training. This property is referred to a generalization. However, with more training data being available, other models such as DNN may be lead to better predictions (with higher accuracy).

Such DNNs are implemented by combining layers of processing units where a unit itself has trainable parameters. Commonly used types of layers are convolutional layers, dense layers (also referred to as fully connected layers) and recurrent layers. They differ in which types of units are implemented and how these units are connected with each other. Additional types of layers are used to support the training process, where training refers to the process of optimizing the parameters $\Theta$ by means of numerical optimization.

In the following, further embodiments are provided.

An apparatus and/or a method for controlling the level of an artificially generated reverberation signal to be added to an audio signal using a model of the perceived intensity of reverberation in the original input signal are provided.

According to an embodiment, the input signal may, e.g., be dereverberated to attenuate the original reverberation signal components.

In an embodiment, a linear regression model may, e.g., be employed with different audio feature values as input.

According to an embodiment, sub-band SFM and/or sub-band ICC may, e.g., be employed as input audio features.

In an embodiment, tunable scaling values for altering the models prediction may, e.g., be employed, which depend on audio features values to compensate for altered interaction of artificial reverberation and dereverberated input signal in comparison to original reverberation and direct signal.

According to an embodiment, tunable scaling values may, e.g., be employed, which depend on sub-band ICC and sub-band STM.

In an embodiment, a ring buffer with high overlap for real-time processing may, e.g., be employed.

According to an embodiment, adaptive temporal smoothing may, e.g., be employed to adjust the amount of smoothing according to changes in the input signal.

In an embodiment, changes in loudness and models prediction may, e.g., be evaluated to control the smoothing coefficient of temporal recursive averaging.

According to an embodiment, track changes may, e.g., be detected depending on changes in the variance of audio features to temporarily reduce the smoothing coefficient of temporal recursive averaging and to reset the ring buffer.

In an embodiment, a mapping function fitted to listening test data may, e.g., be employed to convert tuned model predictions into reverb send gains.

The proposed concepts may, for example, be applied for sound reproduction in a car to mimic acoustic environments of larger size and pleasantly sounding spatial properties. Emulating an acoustic environment is achieved by processing the audio input signal such that reverberant signal components of the output signal are perceptually similar to a reproduction of the direct signal components in the new environment. The implementation has low latency and low workload.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus. Some or all of the method steps may be executed by (or using) a hardware apparatus, like for example, a microprocessor, a programmable computer or an electronic circuit. In some embodiments, one or more of the most important method steps may be executed by such an apparatus.

Depending on certain implementation requirements, embodiments of the invention can be implemented in hardware or in software or at least partially in hardware or at least partially in software. The implementation can be performed using a digital storage medium, for example a floppy disk, a DVD, a Blu-Ray, a CD, a ROM, a PROM, an EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may for example be stored on a machine readable carrier.

Other embodiments comprise the computer program for performing one of the methods described herein, stored on a machine readable carrier.

In other words, an embodiment of the inventive method is, therefore, a computer program having a program code for performing one of the methods described herein, when the computer program runs on a computer.

A further embodiment of the inventive methods is, therefore, a data carrier (or a digital storage medium, or a computer-readable medium) comprising, recorded thereon, the computer program for performing one of the methods described herein. The data carrier, the digital storage medium or the recorded medium are typically tangible and/or non-transitory.

A further embodiment of the inventive method is, therefore, a data stream or a sequence of signals representing the computer program for performing one of the methods described herein. The data stream or the sequence of signals may for example be configured to be transferred via a data communication connection, for example via the Internet.

A further embodiment comprises a processing means, for example a computer, or a programmable logic device, configured to or adapted to perform one of the methods described herein.

A further embodiment comprises a computer having installed thereon the computer program for performing one of the methods described herein.

A further embodiment according to the invention comprises an apparatus or a system configured to transfer (for example, electronically or optically) a computer program for performing one of the methods described herein to a receiver. The receiver may, for example, be a computer, a mobile device, a memory device or the like. The apparatus or system may, for example, comprise a file server for transferring the computer program to the receiver.

In some embodiments, a programmable logic device (for example a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The apparatus described herein may be implemented using a hardware apparatus, or using a computer, or using a combination of a hardware apparatus and a computer.

The methods described herein may be performed using a hardware apparatus, or using a computer, or using a combination of a hardware apparatus and a computer.

The above described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

References

[1] Paulus, J., Uhle, C., and Herre, J., "Perceived Level of Late Reverberation in Speech and Music," in Proc. AES 130th Conv., 2011.

[2] Gardner, W. G. and Griesinger, D., "Reverberation level matching experiments," in Proc. Sabine Centennial Symposium, Acoust. Soc. of Am., 1994.

[3] Leonard, B., King, R., and Sikora, G., "The Effect of Playback System on Reverberation Level Preference," in Audio Engineering Society Convention 134, 2013.

[4] Leonard, B., King, R., and Sikora, G., "The Effect of Acoustic Environment on Reverberation Level Preference," in Audio Engineering Society Convention 133, 2012.

[5] Sarroff, A. M. and Bello, J. P., "Toward a Computational Model of Perceived Spaciousness in Recorded Music," J. Audio Eng. Soc, 59(7/8), pp. 498-513, 2011.

[6] Uhle, C., Paulus, J., and Herre, J., "Predicting the Perceived Level of Late Reverberation Using Computational Models of Loudness," in Proc. 17th Int. Conf. on Digital Signal Process. (DSP), 2011.

[7] Paulus, J., Uhle, C., Herre, J., and Höpfel, M., "A Study on the Preferred Level of Late Reverberation in Speech and Music," in Proc. of the 60th Int. Conf. of Audio Eng. Soc., 2016.

[8] Gilleland, E., Confidence Intervals for Forecast Verification, National Center For Atmospheric Research, Boulder, Colorado, 2010.

[9] Allen, J., Berkeley, D., and Blauert, J., "Multimicrophone Signal-Processing Technique to Remove Room Reverberation from Speech Signals," J. Acoust. Soc. Am., 62, 1977.

[10] Gray, A. H. and Markel, J. D., "A Spectral-Flatness Measure for Studying the Autocorrelation Method of Linear Prediction of Speech Analysis," IEEE Trans. Acoust., Speech, and Sig. Process., 22, pp. 207-217, 1974.

[11] James, G., Witten, D., Hastie, T., and Tibshirani R., editors, "An Introduction to Statistical Learning: with Applications in R," number 103 in Springer Texts in Statistics, Springer, New York, 2013.

**Claims**

1. An apparatus for processing an audio input signal comprising one or more audio channels to obtain an audio output signal, wherein the apparatus comprises:

   a reverberation gain determiner (110) configured to determine reverberation gain information depending on the audio input signal, and
   a signal processor (120) configured to obtain the audio output signal depending on the reverberation gain information by adding artificial reverberation to the audio input signal or to a preprocessed audio signal, which depends on the audio input signal.

2. An apparatus according to claim 1,
   wherein the reverberation gain determiner (110) is configured to determine the reverberation gain information depending on an estimate of a perceived intensity of reverberation in the audio input signal.

3. An apparatus according to claim 2,
   wherein the reverberation gain determiner (110) is configured to determine the reverberation gain information by employing a model that returns the estimate of the perceived intensity of reverberation in the audio input signal on receiving information on one or more features of the audio input signal.

4. An apparatus according to claim 3,
   wherein the model employed by the reverberation gain determiner (110) is a linear regression model using one or more feature values of the one or more features of the audio input signal as an input for the linear regression model.

5. An apparatus according to claim 3 or 4,

wherein, to obtain the reverb send gain, the reverberation gain determiner (110) is configured to determine a reverb send gain as the reverberation gain information by mapping the estimate of the perceived intensity of reverberation in the audio input signal according to a mapping function.

6. An apparatus according to one of claims 3 to 5,
wherein the one or more features of the audio input signal depend on an inter-channel correlation of at least one of one or more sub-bands of two audio channels of the one or more audio channels of the audio input signal.

7. An apparatus according to one of claims 3 to 6,
wherein the one or more features of the audio input signal depend on an spectral flatness measure of at least one of one or more sub-bands of the one or more audio channels of the audio input signal.

8. An apparatus according to one of claims 3 to 7,

wherein the reverberation gain determiner is configured to determine the estimate of the perceived intensity of reverberation in the audio input signal by employing the model,
wherein the reverberation gain determiner is configured to determine one or more scaling factors depending on the one or more features of the audio input signal, and
wherein the reverberation gain determiner is configured to determine the reverberation gain information depending on the estimate of the perceived intensity of reverberation and depending on the one or more scaling factors.

9. An apparatus according to claim 8,
wherein the one or more scaling factors depend on an inter-channel correlation of at least one of one or more sub-bands of two audio channels of the one or more audio channels of the audio input signal.

10. An apparatus according to claim 8 or 9,
wherein the one or more scaling factors depend on a presence of transient signal components in at least one of the one or more audio channels of the audio input signal.

11. An apparatus according to one of claims 8 to 10,

wherein the one or more scaling factors depend on a spectral transient measure of at least one of the one or more audio channels of the audio input signal,
wherein the spectral transient measure is defined depending on:

$$STM(m,k) = \max\left(Z(m,k) - f_s(Z(m,k)), 0\right)$$

wherein

$$Z(m,k) = g\left(\sum_{i=1}^{N} Y_d(m, b_{k,i})^2\right)$$

wherein m indicates a time index, wherein $k$ indicates a frequency index,
wherein $b_{k,i}$ indicates one of one or more frequency bins in frequency band/sub-band $k$,
wherein $Y_d(m, b_{k,i})$ indicates a magnitude coefficient with time index m for the one or more frequency bins $b_{k,i}$ in frequency band $k$ of said at least one of the one or more audio channels or of a combination of said at least one of the one or more audio channels, and
wherein $f_s()$ denotes a recursive averaging along time and implements a smoothing of the sub-band signal.

12. An apparatus according to one of the preceding claims,

wherein the signal processor (120) is configured to generate the preprocessed audio signal by dereverberating the audio input signal to attenuate original reverberation signal components of the audio input signal, and
wherein the signal processor (120) is configured to obtain the audio output signal depending on the reverberation gain information by adding the artificial reverberation to the preprocessed audio signal.

13. An apparatus according to one of the preceding claims,

wherein the signal processor (120) is configured to generate the preprocessed audio signal by conducting temporal smoothing of the audio input signal, and
wherein the signal processor (120) is configured to obtain the audio output signal depending on the reverberation gain information by adding the artificial reverberation to the preprocessed audio signal.

14. An apparatus according to claim 13,
wherein the signal processor (120) is configured to adjust an amount of the temporal smoothing depending on changes in the audio input signal.
i

15. An apparatus according to claim 13 or 14,
wherein the signal processor (120) is configured to adjust the amount of the temporal smoothing depending on changes in the audio input signal.

16. An apparatus according to claim 15,
wherein the signal processor (120) is configured to adjust the amount of the temporal smoothing depending on a change of a loudness of the audio input signal.

17. An apparatus according to claim 15 or 16, further depending on claim 3,
wherein the signal processor (120) is configured to adjust the amount of the temporal smoothing depending on changes in a variance of the one or more features of the audio input signal.

18. An apparatus according to one of the preceding claims,

wherein the apparatus comprises a ring buffer for receiving the audio input signal or the preprocessed audio signal, and
wherein the signal processor (120) is configured to process the audio input signal or the preprocessed audio signal in the ring buffer to obtain the audio output signal.

19. A method for processing an audio input signal to obtain an audio output signal, wherein the method comprises:

determining reverberation gain information depending on the audio input signal, and
obtaining the audio output signal depending on the reverberation gain information by adding artificial reverberation to the audio input signal or to a preprocessed audio signal which depends on the audio input signal.

20. A computer program for implementing the method of claim 19 when being executed on a computer or signal processor.

Fig. 1

EP 4 247 011 A1

Fig. 2

Fig. 3

EP 4 247 011 A1

Fig. 4

Fig. 5

Fig. 6

EP 4 247 011 A1

Fig. 7

EP 4 247 011 A1

Europäisches
Patentamt

European
Patent Office

Office européen
des brevets

# EUROPEAN SEARCH REPORT

Application Number

EP 22 16 2454

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/275613 A1 (SOULODRE GILBERT ARTHUR JOSEPH [CA]) 1 November 2012 (2012-11-01) | 1,2, 12-20 | INV. H04S7/00 G10L21/0208 |
| A | * paragraph [0095]; figure 3 * <br> * paragraph [0119] – paragraph [0150]; figure 9 * <br> * figure 13 * | 3-11 | |
| X | US 2014/072126 A1 (UHLE CHRISTIAN [US] ET AL) 13 March 2014 (2014-03-13) | 1,18-20 | |
| A | * paragraph [0095] – paragraph [0096]; figure 8 * | 2-17 | |
| X | WO 2014/091375 A1 (KONINKL PHILIPS NV [NL]) 19 June 2014 (2014-06-19) | 1,2, 13-20 | |
| A | * page 21, line 13 – page 28, line 7; figures 9-10 * | 3-12 | |
| X | US 2017/162213 A1 (ANUSHIRAVANI RAMIN [US] ET AL) 8 June 2017 (2017-06-08) | 1,12-20 | |
| A | * paragraph [0023] – paragraph [0043]; figures 2-5 * | 2-11 | TECHNICAL FIELDS SEARCHED (IPC) <br><br> H04S G10L H04R |

The present search report has been drawn up for all claims

| Place of search | Date of completion of the search | Examiner |
|---|---|---|
| Munich | 26 August 2022 | Guillaume, Mathieu |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
........................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 16 2454

This annex lists the patent family members relating to the patent documents cited in the above-mentioned European search report.
The members are as contained in the European Patent Office EDP file on
The European Patent Office is in no way liable for these particulars which are merely given for the purpose of information.

26-08-2022

| Patent document cited in search report | Publication date | Patent family member(s) | Publication date |
|---|---|---|---|
| US 2012275613 A1 | 01-11-2012 | CN 101454825 A | 10-06-2009 |
| | | CN 103402169 A | 20-11-2013 |
| | | EP 2064699 A1 | 03-06-2009 |
| | | JP 4964943 B2 | 04-07-2012 |
| | | JP 5406956 B2 | 05-02-2014 |
| | | JP 5635669 B2 | 03-12-2014 |
| | | JP 2009531722 A | 03-09-2009 |
| | | JP 2012145962 A | 02-08-2012 |
| | | JP 2014052654 A | 20-03-2014 |
| | | US 2008069366 A1 | 20-03-2008 |
| | | US 2008232603 A1 | 25-09-2008 |
| | | US 2012063608 A1 | 15-03-2012 |
| | | US 2012275613 A1 | 01-11-2012 |
| | | WO 2008034221 A1 | 27-03-2008 |
| US 2014072126 A1 | 13-03-2014 | AR 085408 A1 | 02-10-2013 |
| | | AU 2012222491 A1 | 26-09-2013 |
| | | BR 112013021855 A2 | 11-09-2018 |
| | | CA 2827326 A1 | 07-09-2012 |
| | | CN 103430574 A | 04-12-2013 |
| | | EP 2541542 A1 | 02-01-2013 |
| | | EP 2681932 A1 | 08-01-2014 |
| | | ES 2892773 T3 | 04-02-2022 |
| | | JP 5666023 B2 | 04-02-2015 |
| | | JP 2014510474 A | 24-04-2014 |
| | | KR 20130133016 A | 05-12-2013 |
| | | RU 2013144058 A | 10-04-2015 |
| | | TW 201251480 A | 16-12-2012 |
| | | US 2014072126 A1 | 13-03-2014 |
| | | WO 2012116934 A1 | 07-09-2012 |
| WO 2014091375 A1 | 19-06-2014 | NONE | |
| US 2017162213 A1 | 08-06-2017 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **PAULUS, J. ; UHLE, C. ; HERRE, J.** Perceived Level of Late Reverberation in Speech and Music. *Proc. AES 130th Conv.,* 2011
- **GARDNER, W. G. ; GRIESINGER, D.** Reverberation level matching experiments. *Proc. Sabine Centennial Symposium, Acoust. Soc. of Am.,* 1994
- **LEONARD, B. ; KING, R. ; SIKORA, G.** The Effect of Playback System on Reverberation Level Preference. *Audio Engineering Society Convention,* 2013, vol. 134
- **LEONARD, B. ; KING, R. ; SIKORA, G.** The Effect of Acoustic Environment on Reverberation Level Preference. *Audio Engineering Society Convention,* 2012, vol. 133
- **SARROFF, A. M. ; BELLO, J. P.** Toward a Computational Model of Perceived Spaciousness in Recorded Music. *J. Audio Eng. Soc,* 2011, vol. 59 (7/8), 498-513
- **UHLE, C. ; PAULUS, J. ; HERRE, J.** Predicting the Perceived Level of Late Reverberation Using Computational Models of Loudness. *Proc. 17th Int. Conf. on Digital Signal Process. (DSP),* 2011
- **PAULUS, J. ; UHLE, C. ; HERRE, J. ; HÖPFEL, M.** A Study on the Preferred Level of Late Reverberation in Speech and Music. *Proc. of the 60th Int. Conf. of Audio Eng. Soc.,* 2016
- **GILLELAND, E.** Confidence Intervals for Forecast Verification. National Center For Atmospheric Research, 2010
- **ALLEN, J. ; BERKELEY, D. ; BLAUERT, J.** Multimicrophone Signal-Processing Technique to Remove Room Reverberation from Speech Signals. *J. Acoust. Soc. Am.,* 1977, vol. 62
- **GRAY, A. H. ; MARKEL, J. D.** A Spectral-Flatness Measure for Studying the Autocorrelation Method of Linear Prediction of Speech Analysis. *IEEE Trans. Acoust., Speech, and Sig. Process.,* 1974, vol. 22, 207-217
- An Introduction to Statistical Learning: with Applications in R. Springer Texts in Statistics. Springer, 2013